# EUROPÄISCHE PATENTSCHRIFT

(11) **EP 1 271 623 B1**
(45) Veröffentlichungstag und Bekanntmachung des Hinweises auf die Patenterteilung: **01.12.2004**
(21) Anmeldenummer: 02450125.6
(22) Anmeldetag: 23.05.2002
(51) Int. Cl.: H01L 21/00, B25J 15/06, B65G 47/91

(54) **Greifer fur das Handhaben dünner Plättchen**
Gripper for manipulating thin plates
Organe de préhension pour la manipulation de plaques minces

(30) Priorität: 21.06.2001 AT 9602001
(43) Veröffentlichungstag der Anmeldung: 02.01.2003
(73) Patentinhaber: CTR Carinthian Tech Research AG, 9524 Villach/St. Magdalen (AT)
(72) Erfinder: Aigner, Kurt, 9073 Viktring (AT); Binder, Alfred, 9523 Landskron (AT); Ramacciotti, Chiara, 9500 Villach (AT); Hiebler, Gunter, 9523 Landskron (AT); Kroupa, Gerhard, 9500 Villach (AT)
(74) Vertreter: Beer, Manfred, Dipl.-Ing.

(56) Entgegenhaltungen:
- EP-A- 1 091 389
- US-A- 4 735 449
- US-A- 4 969 676
- US-A- 5 692 873

## Beschreibung

Die Erfindung betrifft einen Greifer für das Handhaben dünner Plättchen mit einem Bernoulli-Aufnehmer und mit Anschlägen für das seitliche Abstützen eines vom Bernoulli-Aufnehmer gehaltenen Plättchens. Solche Greifer werden für das Handhaben dünner, insbesondere verbogener Plättchen, wie Glasplättchen, die beispielsweise einseitig beschichtet sind, verwendet.

Ein Greifer der eingangs genannten Gattung ist aus der US 4 969 676 A bekannt.

Aus der EP 1 091 389 A ist ein Bernoulli- und Vakuum- Kombigreifer bekannt. In diesem Greifer, der zum Handhaben dünner, scheibenförmiger Gegenstände, wie Wafer der Halbleitertechnik dient, ist wenigstens eine Austrittöffnung für Druckgas vorgesehen. Das aus dieser Ausströmöffnung austretende Druckgas erzeugt nach dem Bernoulli-Prinzip zwischen dem Gegenstand und dem Greifer eine den Gegenstand zum Greifer hin ziehende Kraft. Zusätzlich besitzt der bekannte Greifer wenigstens einen Vakuumkopf, der mit Unterdruck beaufschlagt wird. Dabei ist vorgesehen den bekannten Greifer so zu benützen, dass beim Aufnehmen eines Gegenstandes sowohl der Bernoulli-Aufnehmer als auch die Unterdruckköpfe betätigt werden, und dass dann nur noch die Unterdruckköpfe benützt werden um einen Wafer am Greifer zu halten.

Der Erfindung liegt die Aufgabe zu Grunde, einen Greifer zur Verfügung zu stellen, mit dem dünne Plättchen ohne Berühren einer ihrer Großflächen lediglich unter Abstützen an ihren Rändern erfasst, transportiert und definiert abgelegt werden können. Dabei soll mit dem erfindungsgemäßen Greifer auch das Handhaben von verbogenen und verspannten Plättchen möglich sein und diese Plättchen sollen für die weitere Bearbeitung planarisiert auf einen Träger, beispielsweise einen (Vakuum-) Chuck, abgelegt werden können.

Gelöst wird diese Aufgabe erfindungsgemäß mit einem Greifer, der sich dadurch auszeichnet, daß wenigstens eine Planarisierungsdüse, die mit Druckgas beaufschlagbar ist, vorgesehen ist, und ... Bevorzugte und vorteilhafte Ausgestaltungen des erfindungsgemäßen Greifers sind Gegenstand der Unteransprüche.

Mit dem erfindungsgemäßen Greifer können dünne Plättchen, wie beispielsweise (einseitig beschichtete) Glasplättchen, von einer Palette aufgenommen werden, wozu der Greifer über dem Plättchen positioniert und der Bernoulli-Aufnehmer des Greifers aktiviert wird. Durch den Bernoulli-Aufnehmer wird das vom Greifer aufgenommene Plättchen berührungslos gehalten und lediglich an seinem Rand durch die Anschläge abgestützt.

Wenn ein von dem erfindungsgemäßen Greifer gehaltenes Plättchen auf einem Träger, z.B. auf einem (Vakuum-)Chuck abgelegt werden soll, ist es für das sichere Ablegen und das zuverlässige Halten des Plättchens auf dem Träger erforderlich, dass das Plättchen eben ist. Hiezu sind in dem erfindungsgemäßen Greifer Planarisierungsdüsen vorgesehen, die nach dem Abschalten des Bernoulli-Aufnehmers mit Druckgas beaufschlagt werden und das Plättchen plan gegen den Träger (z.B. den Vakuumchuck) drücken, so dass das Plättchen von dem Träger sicher gehalten wird und für die weitere Bearbeitung bereit ist.

Die in dem erfindungsgemäßen Greifer vorgesehenen Planarisierungsdüsen, beispielsweise sind bis zu vier Planarisierungsdüsen vorgesehen, sind so ausgelegt und angeordnet, dass durch einen aus ihnen austretenden Gasstoß das Plättchen, wenn es auf einen weiteren Träger, z.B. einen Vakuumchuck abgelegt wird, planarisiert wird.

Bevorzugt ist, wenn die seitlichen Anschläge in einem den Bernoulli-Aufnehmer und die Planarisierungsdüse haltenden Träger federnd geführt sind. Bei dieser Ausführungsform wird ein vom Greifer erfasstes Plättchen lediglich an einem Teil seines Randes abgestützt, indem das Plättchen mit seinem Rand gegen die federnden Anschläge anliegt. Wenn bei dem erfindungsgemäßen Greifer die an diesem vorgesehenen Anschläge derart federnd geführt sind, dass sie in einer Richtung quer zur Hauptebene des Greifers nachgeben, können diese Anschläge auch zum Positionieren des Greifers in der richtigen Höhe über einem aufzunehmenden Plättchen herangezogen werden (die Anschläge sind dann völlig eingefahren).

Die federnde Ausführung der Anschläge des erfindungsgemäßen Greifers, die bevorzugt so ausgebildet ist, dass die Anschläge durch Federmittel in ihre gegenüber dem Bernoulli-Aufnehmer vorstehende Lage belastet sind, erlaubt es auch, bei nicht exakt ebenen Paletten, auf welchen die aufzunehmenden Plättchen liegen, den Greifer für ein richtiges, berührungsfreies Aufnehmen der Plättchen durch den Bernoulli-Aufnehmer zu positionieren. Auch erlauben es die federnden Anschläge, den Greifer so zu positionieren, dass er auch bei verzogenen und/oder verbogenen Plättchen benützt werden kann, ohne die Plättchen zu berühren, wobei der für das sichere Aufnehmen von verbogenen oder verzogenen Plättchen entsprechende Abstand des Greifers während des Aufnahmevorganges von der Palette, auf der die Plättchen liegen, gewährleistet und eine sichere Funktion der seitlichen Anschläge möglich ist.

Um sicherzustellen, dass das Plättchen gegen die Anschläge anliegt, kann vorgegeben sein, dass die Endfläche des Bernoulli-Aufnehmers gegenüber der Hauptebene des Greifers schräggestellt ist, wobei die Endfläche des Bernoulli-Aufnehmers von einer Seite des Greifers ohne seitlichen Anschlag zu dem dieser Seite gegenüberliegenden Anschlag hin abfällt. Dadurch wirkt auf das Plättchen eine Kraft ein, die das Plättchen gegen einen der seitlichen Anschläge drückt. Der Bernoulli-Aufnehmer kann asymmetrisch gestaltet werden, indem im Falle eines Bernoulli-Aufnehmers mit mehreren Einzeldüsen, einzelne der Düsen größer ausgestaltet werden als andere Düsen.

In einer Ausführungsform des erfindungsgemäßen Greifers ist vorgesehen, dass der Bernoulli-Aufnehmer eine ringförmige Düse aufweist, die asymmetrisch ausgebildet ist und deren Austrittsquerschnitt in einem Bereich größer ist als in einem anderen Bereich der Düse.

Bevorzugt sind die Anschläge nicht als durchgehende Leisten ausgebildet, sondern weisen in einer Ausführungsform an ihren freien Rändern zu den Rändern hin offene Ausnehmungen auf, so dass das vom Bernoulli-Aufnehmer abströmende Gas ungehindert seitlich austreten kann und sich keine Wirbel bilden und/oder sich keine Flatterbewegungen des vom Bernoulli-Aufnehmer gehaltenen Plättchens ergeben.

Die seitlichen Anschläge sind bei rechteckigen oder quadratischen Plättchen bevorzugt so angeordnet, dass das Plättchen mit wenigstens drei seiner Seiten an den Anschlägen anliegt, wenn es von dem erfindungsgemäßen Greifer durch Aktivieren des Bernoulli-Aufnehmers getragen wird. Wenn während des Transportes von der Aufnahmestelle zur Abgabestelle größere Beschleunigungen auftreten, kann freilich auch ein vierter Anschlag vorgesehen sein.

Wenn von dem erfindungsgemäßen Greifer Plättchen aufzunehmen sind, die eine andere Umrissform als rechteckig oder quadratisch aufweisen, sind die seitlichen Anschläge entsprechend dem Aussenumfang der Plättchen geformt, beispielweise können die Anschläge bei kreisrunden Plättchen kreissegmentförmig ausgeführt sein.

In einer Ausführungsform des erfindungsgemäßen Greifers ist vorgesehen, dass ein auf die nach oben weisende Großfläche des aufzunehmenden Plättchens gerichteter Sensor vorgesehen ist, der die Lage des höchsten Bereiches des Plättchens erfasst. Dabei kann vorgesehen sein, dass der Sensor neben dem Bernoulli-Aufnehmer angeordnet ist. Durch einen solchen Sensor, der beispielsweise in der Nähe des Bernoulli-Aufnehmers angeordnet ist, kann zuverlässig verhindert werden, dass der Greifer, wenn er über einem Plättchen in Stellung gebracht wird, um das Plättchen aufzunehmen, das Plättchen berührt. Diese Sensoren, die auf die obere Großfläche des aufzunehmenden Plättchens gerichtet sind und deren Lage (Abstand von der Palette, auf der die Plättchen liegen) ansprechen, können beispielsweise faseroptische oder kapazitative Sensoren sein.

In einer Ausführungsform ist bei dem erfindungsgemäßen Greifer vorgesehen, dass wenigstens ein auf das aufzunehmende Plättchen gerichteter, die Lage des Plättchens erfassender Lage-Sensor vorgesehen ist. Ein solcher Sensor erlaubt es, den Greifer gegenüber dem aufzunehmenden Plättchen richtig auszurichten. Bevorzugt ist eine zentrische Ausrichtung des Greifers über dem Plättchen. Ein solcher Sensor kann beispielsweise ein optischer Fasersensor sein. Wenn ein einziger Sensor nicht hinreicht, um die Position des Plättchens, das aufzunehmen ist, richtig zu erfassen, können auch mehrere Sensoren vorgesehen sein. Bevorzugt ist dabei, dass der wenigstens eine Lage-Sensor mit Abstand vom Bernoulli-Aufnehmer angeordnet ist.

Ein Vorteil des erfindungsgemäßen Greifers ist es, dass er auch für den automatisierten Einsatz ausgelegt und an einem Roboter befestigt werden kann. Es versteht sich, dass der erfindungsgemäße Greifer auch für den manuellen Einsatz ausgelegt sein kann.

Mit dem erfindungsgemäßen Greifer kann beispielsweise wie folgt gearbeitet werden:

Nach dem Positionieren des Greifers mit Hilfe des wenigstens einen Sensors in der Art, dass der Bernoulli-Aufnehmer beispielsweise etwa 1 mm über dem Plättchen angeordnet ist, wird der Bernoulli-Aufnehmer mit Druckgas (Luft oder Stickstoff) beaufschlagt. Dadurch wird das Plättchen vom Greifer angezogen und schwebt auf einem Gaspolster unter dem über dem Plättchen angeordneten Bernoulli-Aufnehmer. Durch einen schräggestellten und/oder asymmetrisch ausgebildeten Bernoulli-Aufnehmer wird das Plättchen zu einem der seitlichen Anschläge hin gedrückt und durch die anderen Anschläge seitlich stabilisiert, insbesondere wenn es sich um ein rechteckiges Plättchen handelt.

Nachdem ein Plättchen so aufgenommen worden ist, wird es mit Hilfe des Greifers von der Aufnahmestelle (z.B. von einer Palette) weg zu einer weiteren Behandlungsstelle bewegt und dort auf einen Träger, beispielsweise einen (Vakuum-)Chuck, abgelegt. Zum Ablegen des Plättchens wird der Greifer mit dem Plättchen über dem Träger positioniert. Dabei ist durch die federnd geführten Anschläge ein Ausrichten des Greifers parallel zum Träger möglich. Nun wird die Gaszufuhr zum Bernoulli-Aufnehmer unterbrochen und von oben her aus den Planarisierungsdüsen ein kurzer Gasstoß auf das Plättchen gerichtet. Durch diesen Gasstoß fällt das Plättchen vom Greifer auf den Träger und wird planarisiert an den Träger angedrückt. Durch Aktivieren des Trägers, beispielsweise Beaufschlagen einer Vakuumdüse, wird das Plättchen nunmehr vom Träger gehalten und der Greifer ist für das erneute Umsetzen eines Plättchens von der Aufnahmestelle (Palette) zu einer Bearbeitungsstelle für das Plättchen (Vakuumchuck) bereit.

Weitere Einzelheiten, Merkmale und Vorteile des erfindungsgemäßen Greifers ergeben sich aus der nachstehenden Beschreibung eines Ausführungsbeispieles unter Bezugnahme auf die Zeichnungen.

Es zeigt:
Fig. 1 einen Träger von unten gesehen,

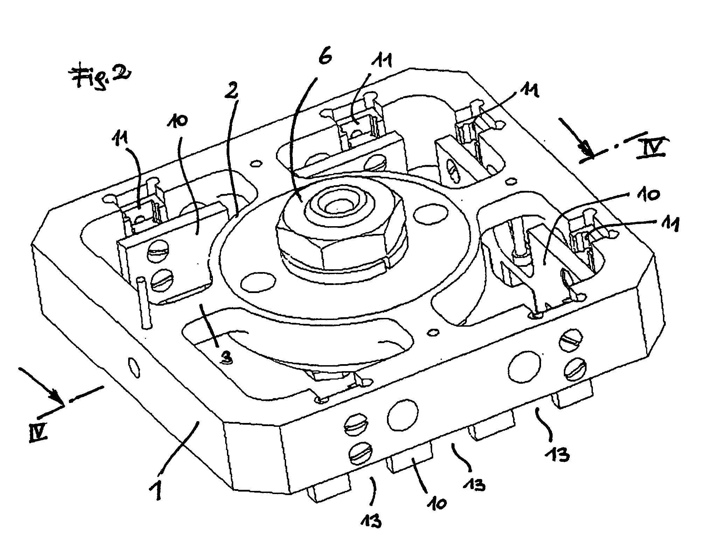

Fig. 2 den Träger von oben gesehen,
Fig. 3 den Träger in Ansicht wie in Fig. 2 zusammen mit einem aufzunehmenden Plättchen und
Fig. 4 einen Schnitt längs der Linie IV-IV in Fig. 2.

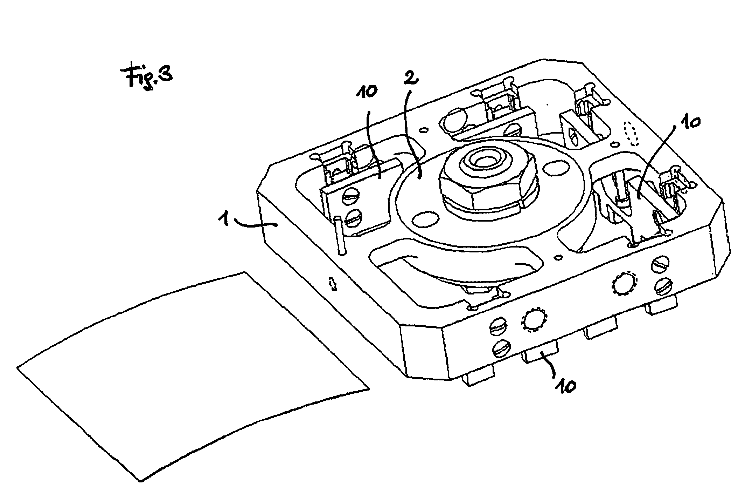

In dem gezeigten und im folgenden beschriebenen Ausführungsbeispiel ist der erfindungsgemäße Greifer für das Aufnehmen von rechteckigen Plättchen (vgl. Fig. 3) bestimmt. Wie bereits oben angedeutet, ist es nicht zwingend, dass der Greifer für das Aufnehmen rechteckiger Plättchen ausgelegt ist, vielmehr kann er nach entsprechender Anpassung seiner Grundform und der Form seiner Anschläge für das Aufnehmen von Plättchen mit weitgehend beliebig geformter Umrissform, z.B. auch von kreisrunden Plättchen, ausgelegt werden.

In dem Ausführungsbeispiel besteht der erfindungsgemäße Greifer aus einem Rahmen 1 mit einem mittleren Träger 2, der über Stege 3 mit dem Rahmen 1 verbunden ist. An dem mittleren Träger 2 sind einerseits ein Bernoulli-Aufnehmer 4 und im gezeigten Ausführungsbeispiel vier Planarisierungsdüsen 5 vorgesehen. Der Bernoulli-Aufnehmer 4 besitzt im gezeigten Ausführungsbeispiel mehrere zu seiner unteren Endfläche 20 geneigte Düsen, durch die Druckgas (Luft oder Stickstoff) austritt. Der Bernoulli-Aufnehmer 4 kann über einen an der Oberseite des mittleren Trägers 2 vorgesehenen Anschluss 6 mit Druckgas beaufschlagt werden.

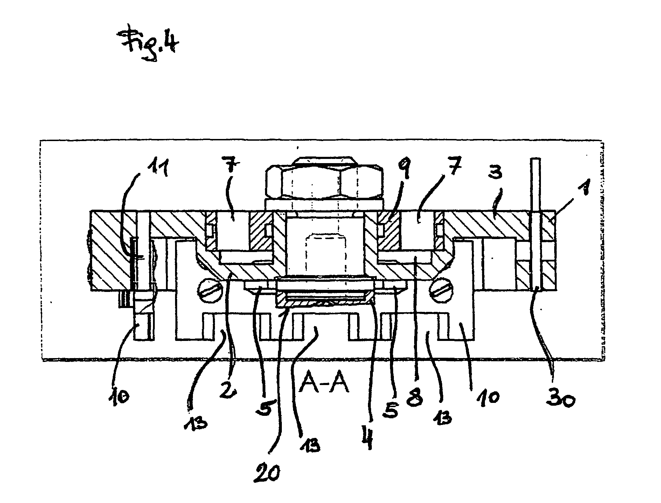

Rings um den Bernoulli-Aufnehmer 4 sind im Ausführungsbeispiel vier Planarisierungsdüsen 5 vorgesehen, die über zwei an der Oberseite des Trägers 2 vorgesehene Anschlüsse 7 mit Druckgas beaufschlagt werden. Wie die Schnittdarstellung der Fig. 4 zeigt, ist der mittlere Träger 2 hohl ausgeführt, so dass über die Druckgasanschlüsse 7 eine im mittleren Träger 2 vorgesehene Kammer 8 mit Gas beaufschlagt wird. So werden alle Planarisierungsdüsen 5 gleichzeitig mit Druckgas beaufschlagt. Die Kammer 8 im mittleren Träger 2 ist nach oben hin durch einen Deckel 9 verschlossen.

Am Rahmen 1 sind an drei seiner Seiten Anschläge 10 vorgesehen. Diese Anschläge 10 sind mit Hilfe von Führungen 11, z.B. Schneebergerführungen (Linearführungen mit in Nuten aufgenommenen Wälzkörpern), in einer Richtung quer zur Ebene des Rahmens 1 verschiebbar geführt und werden durch Federn 12 in ihre nach unten über den Rahmen 1 vorstehende Lage belastet.

Die freien Ränder der seitlichen Anschläge 10 sind mit zu ihrem Rand hin offenen Aussparungen 13 versehen, so dass während des Haltens eines Plättchens durch den Bernoulli-Aufnehmer 4 das aus dem Bernoulli-Aufnehmer 4 austretende Gas ohne Wirbelbildung abströmen kann und Flatterbewegungen des dünnen, am Greifer gehaltenen Plättchens vermieden werden.

Fig. 4 zeigt, dass die untere Endfläche 20 des Bernoulli-Aufnehmers 4 gegenüber dem Rahmen 1 und den Anschlägen 10, also gegenüber der Haupterstreckungsebene des Greifers schräg gestellt ist und von der Seite des Greifers, an der kein Anschlag 10 vorgesehen ist, zu dem der offenen Seite gegenüberliegenden Anschlag 10 hin abfallend ausgebildet ist. Dadurch wirkt auf ein von dem Bernoulli-Aufnehmer 4 gehaltenen Plättchen eine Kraft ein, die dieses in Richtung auf den in Fig. 4 links liegenden Anschlag 10 belastet. So wird das Plättchen von den drei Anschlägen 10 sicher gehalten.

Wie bereits angedeutet, kann eine auf das Plättchen in Richtung seiner Ebene einwirkende Kraft, die das Plättchen gegen einen Anschlag 10 drückt, auch dadurch erreicht werden, dass der Bernoulli-Aufnehmer 4 durch asymmetrische Ausbildung seiner Austrittsdüsen (Austrittsdüsen mit größerer Austrittsfläche, z.B. mit größerem Durchmesser, und diesen z.B. diametral gegenüberliegend Austrittsdüsen mit kleinerer Austrittsöffnung, z.B. mit kleinerem Durchmesser) oder seiner ringförmigen Austrittsdüse mit einem Bereich mit geringerer Austrittsbreite und mit einem (diametral gegenüberliegenden) Bereich mit größerer Austrittsbreite so ausgebildet wird, dass er auf das Plättchen eine seitwärts gerichtete Kraft ausübt.

Im Rahmen 1 des erfindungsgemäßen Greifers ist noch eine Aufnahmestelle für wenigstens einen Sensor, beispielsweise einen faseroptischen Sensor 30, vorgesehen. Es versteht sich, dass in dem Rahmen 1 des erfindungsgemäßen Greifers 4 auch mehrere Sensoren vorgesehen sein können, wenn dies auf Grund der Anordnung der aufzunehmenden Plättchen auf einer Palette und/oder durch die Umrissform der aufzunehmenden Plättchen erforderlich ist. Da Plättchen in der Regel aber auf den Paletten, von denen sie aufzunehmen sind, in genau ausgerichteter Lage angeordnet sind, genügt in der Regel ein Positionierungssensor, um den erfindungsgemäßen Greifer in die für das Aufnehmen eines Plättchens richtige Position zu bewegen.

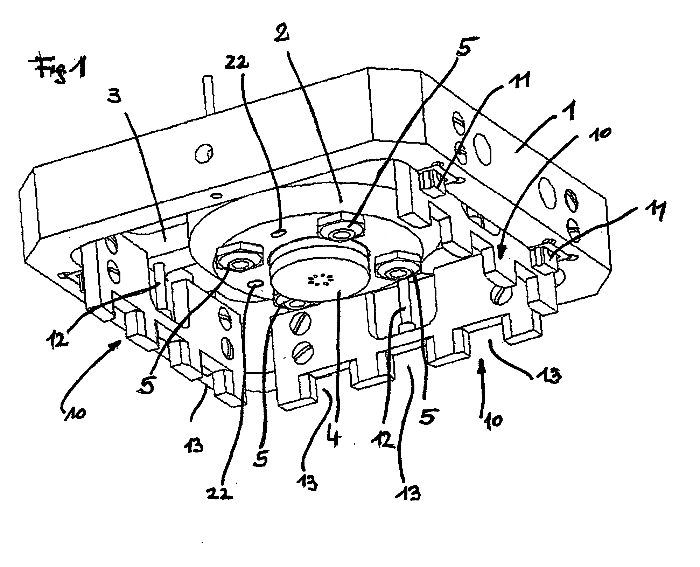

Zusätzlich kann, insbesondere in der Nähe des Bernoulli-Aufnehmers 4, wenigstens ein weiterer Sensor 22 (Fig. 1) vorgesehen sein, mit dem die Lage des höchsten Bereiches eines aufzunehmenden auf der Aufnahmestelle (Palette) liegenden Plättchens erfasst wird. So kennt die Steuerung für die Bewegungen des Greifers die Lage des höchsten Punktes des Plättchens und verhindert, dass der Greifer (insbesondere dessen Bernoulli-Aufnehmer) das Plättchen berührt, wenn er über dem Plättchen zum Aufnehmen desselben in Stellung gebracht wird.

Zusammenfassend kann ein Ausführungsbeispiel der Erfindung wie folgt beschrieben werden:

Ein Greifer zum Aufnehmen von dünnen Plättchen besitzt wenigstens einen Bernoulli-Aufnehmer 4 und federnd geführte seitliche Anschläge 10 für das vom Bernoulli-Aufnehmer 4 berührungslos gehaltene Plättchen. Um ein vom Greifer gehaltenes Plättchen planarisiert auf einen weiteren Träger, wie beispielsweise einen Vakuumchuck, ablegen zu können, sind rings um den Bernoulli-Aufnehmer 4 zwei oder mehrere Planarisierungsdüsen 5 vorgesehen, aus denen nach dem Abschalten der Gaszufuhr zum Bernoulli-Aufnehmer 4 Druckgas austritt, um ein Plättchen plan gegen den weiteren Träger, auf den das Plättchen abzulegen ist, zu drücken. Dem Greifer kann wenigstens ein Sensor zum Erfassen der Lage des aufzunehmenden Plättchens zugeordnet sein. Weiters kann ein Sensor oder mehrere Sensoren für das Erfassen der Höhe des Plättchens (Auswölbung desselben) vorgesehen sein, um zu verhindern, dass der Greifer auf das Plättchen aufläuft.

## Patentansprüche

1. Greifer für das Handhaben dünner Plättchen mit einem Bernoulli-Aufnehmer (4) und mit Anschlägen (10) für das seitliche Abstützen eines vom Bernoulli-Aufnehmer (4) gehaltenen Plättchens, **dadurch gekennzeichnet, daß** wenigstens eine Planarisierungsdüse (5), die mit Druckgas beaufschlagbar ist, vorgesehen ist, und dass die Planarisierungsdüse (5) beim Ablegen eines Plättchens nach dem Abschalten des Bernoulli-Aufnehmers (4) mit Druckgas beaufschlagt ist.

2. Greifer nach Anspruch 1, **dadurch gekennzeichnet, dass** die seitlichen Anschläge (10) in einem den Bernoulli-Aufnehmer (4) und die Planarisierungsdüse (5) haltenden Träger (1) federnd geführt sind.

3. Greifer nach Anspruch 1 oder 2, **dadurch gekennzeichnet, dass** die Anschläge (10) an ihren freien Rändern zu diesen Rändern hin offene Aussparungen (13) aufweisen.

4. Greifer nach einem der Ansprüche 1 bis 3, **dadurch gekennzeichnet, dass** die Anschläge (10) durch Federmittel in ihre gegenüber dem Bernoulli-Aufnehmer (4) vorstehende Lage belastet sind.

5. Greifer nach einem der Ansprüche 1 bis 4, **dadurch gekennzeichnet, dass** die Planarisierungsdüsen (5) um den Bernoulli-Aufnehmer (4) herum angeordnet sind.

6. Greifer nach einem der Ansprüche 1 bis 5, **dadurch gekennzeichnet, dass** die Endfläche (20) des Bernoulli-Aufnehmers (4) gegenüber der Hauptebene des Greifers schräggestellt ist, wobei die Endfläche (20) des Bernoulli-Aufnehmers (4) von einer Seite des Greifers ohne seitlichen Anschlag (10) zu dem dieser Seite gegenüberliegenden Anschlag (10) hin abfällt.

7. Greifer nach einem der Ansprüche 1 bis 5, **dadurch gekennzeichnet, dass** der Bernoulli-Aufnehmer (4) mehrere, zu seiner Endfläche (20) schräggestellte, Austrittsdüsen aufweist.

8. Greifer nach einem der Ansprüche 1 bis 5, **dadurch gekennzeichnet, dass** der Bernoulli-Aufnehmer (4) eine ringförmige Düse aufweist, die asymmetrisch ausgebildet ist und deren Austrittsquerschnitt in einem Bereich größer ist als in einem anderen Bereich der Düse.

9. Greifer nach einem der Ansprüche 1 bis 8, **dadurch gekennzeichnet, dass** ein auf die nach oben weisende Großfläche des aufzunehmenden Plättchens gerichteter Sensor (22) vorgesehen ist, der die Lage des höchsten Bereiches des Plättchens erfasst.

10. Greifer nach Anspruch 9, **dadurch gekennzeichnet, dass** der Sensor (22) neben dem Bernoulli-Aufnehmer (4) angeordnet ist.

11. Greifer nach einem der Ansprüche 1 bis 10, **dadurch gekennzeichnet, dass** wenigstens ein auf das aufzunehmende Plättchen gerichteter, die Lage des Plättchens erfassender Lage-Sensor (30) vorgesehen ist.

12. Greifer nach Anspruch 11, **dadurch gekennzeichnet, dass** der wenigstens eine Lage-Sensor (30) mit Abstand vom Bernoulli-Aufnehmer (4) angeordnet ist.

13. Greifer nach Anspruch 12, **dadurch gekennzeichnet, dass** der Abstand des wenigstens einen Lage-Sensors (30) vom Bernoulli-Aufnehmer (4) größer ist als der Abstand der seitlichen Anschläge (10) vom Bernoulli-Aufnehmer (4).

## Claims

1. Gripper for manipulating thin plates, having a Bernoulli pick-up (4) and having limit stops (10) for the lateral support of a plate held by the Bernoulli pick-up (4), **characterised in that** at least one planarisation nozzle (5), which can be supplied with compressed gas, is provided, and **in that** the planarisation nozzle (5) is supplied with compressed gas during deposition of a plate after the switching-off of the Bernoulli pick-up (4).

2. Gripper according to claim 1, **characterised in that** the lateral limit stops (10) are guided in a resilient manner in a carrier (1) which holds the Bernoulli pick-up (4) and the planarisation nozzle (5).

3. Gripper according to claim 1 or 2, **characterised in that** the limit stops (10) have recesses (13) on their free edges which are open towards these edges.

4. Gripper according to one of the claims 1 to 3, **characterised in that** the limit stops (10) are loaded by resilient means in their position which projects relative to the Bernoulli pick-up (4).

5. Gripper according to one of the claims 1 to 4, **characterised in that** the planarisation nozzles (5) are disposed around the Bernoulli pick-up (4).

6. Gripper according to one of the claims 1 to 5, **characterised in that** the end face (20) of the Bernoulli pick-up (4) is inclined relative to the main plane of the gripper, the end face (20) of the Bernoulli pick-up (4) tapering away from a side of the gripper without a lateral limit stop (10) towards the limit stop (10) which is situated opposite this side.

7. Gripper according to one of the claims 1 to 5, **characterised in that** the Bernoulli pick-up (4) has a plurality of outlet nozzles which are inclined towards its end face (20).

8. Gripper according to one of the claims 1 to 5, **characterised in that** the Bernoulli pick-up (4) has an annular nozzle which has an asymmetrical configuration and the outlet cross-section of which is larger in one region than in another region of the nozzle.

9. Gripper according to one of the claims 1 to 8, **characterised in that** a sensor (22) is provided which is directed towards the upwardly pointing large surface of the plate to be picked up and detects the position of the highest region of the plate.

10. Gripper according to claim 9, **characterised in that** the sensor (22) is disposed adjacent to the Bernoulli pick-up (4).

11. Gripper according to one of the claims 1 to 10, **characterised in that** at least one position sensor (30) is provided which is directed towards the plate to be picked up and detects the position of the plate.

12. Gripper according to claim 11, **characterised in that** the at least one position sensor (30) is disposed at a spacing from the Bernoulli pick-up (4).

13. Gripper according to claim 12, **characterised in that** the spacing of the at least one position sensor (30) from the Bernoulli pick-up (4) is greater than the spacing of the lateral limit stops (10) from the Bernoulli pick-up (4).

## Revendications

1. Organe de préhension pour la manipulation de plaquettes minces, comprenant un réceptacle de Bernoulli (4) et des butées (10) pour assurer le soutien latéral d'une plaquette maintenue dans le réceptacle de Bernoulli (4), **caractérisé en ce qu'**il est prévu au moins une tuyère de mise à plat (5) qui peut être actionnée par du gaz sous pression, cette tuyère étant actionnée par ce gaz sous pression lors de l'abandon d'une plaquette par mise hors service du réceptacle de Bernoulli (4).

2. Organe de préhension selon la revendication 1, **caractérisé en ce que** les butées latérales (10) sont guidées élastiquement dans un support (11) portant le réceptacle de Bernoulli (4) et la tuyère de mise à plat (5).

3. Organe de préhension selon la revendication 1 ou 2, **caractérisé en ce que** les butées (10) présentent le long de leurs bords libres des évidements (13) ouverts en direction de ces bords.

4. Organe de préhension selon une des revendications 1 à 3, **caractérisé en ce que** les butées (10) sont actionnées par des moyens élastiques dans le sens les amenant à la position où elles sont en saillie par rapport au réceptacle de Bernoulli (4).

5. Organe de préhension selon une des revendications 1 à 4, **caractérisé en ce que** les tuyères de mise à plat (5) sont disposées autour du réceptacle de Bernoulli (4).

6. Organe de préhension selon une des revendications 1 à 5, **caractérisé en ce que** la surface d'extrémité (20) du réceptacle de Bernoulli (4) est inclinée par rapport au plan principal de l'organe de préhension, cette surface d'extrémité (20) descendant en pente d'un côté de l'organe de préhension dépourvu de butée latérale, en direction de la butée (10) située en face de ce côté.

7. Organe de préhension selon une des revendications 1 à 5, **caractérisé en ce que** le réceptacle de Bernoulli (4) présente plusieurs tuyères de sortie inclinées par rapport à la surface d'extrémité (20) de ce réceptacle.

8. Organe de préhension selon une des revendications 1 à 5, **caractérisé en ce que** le réceptacle de Bernoulli (4) présente une tuyère annulaire asymétrique, dont la section de sortie est plus grande dans une zone que dans une autre zone de la tuyère.

9. Organe de préhension selon une des revendications 1 à 8, **caractérisé en ce qu'**il est prévu, orienté vers la grande surface regardant vers le haut de la plaquette à recevoir, un capteur (22) qui détecte la position de la zone la plus élevée de la plaquette.

10. Organe de préhension selon la revendication 9, **caractérisé en ce que** le capteur (22) est monté à côté du réceptacle de Bernoulli (4).

11. Organe de préhension selon une des revendications 1 à 10, **caractérisé en ce qu'**il est prévu au moins un détecteur (30) de position dirigé vers la plaquette à recevoir et saisissant la position de celle-ci.

12. Organe de préhension selon la revendication 11, **caractérisé en ce que** le détecteur de position (30), au nombre d'un au moins, est monté à une certaine distance du réceptacle de Bernoulli (4).

13. Organe de préhension selon la revendication 12, **caractérisé en ce que** la distance entre le détecteur de position (30), au nombre d'un au moins, et le réceptacle de Bernoulli (4) est plus grande que la distance entre les butées latérales (10) et le réceptacle de Bemoulli (4).
